## Europäisches Patentamt

## European Patent Office

(19)

## Office européen des brevets

(11) Veröffentlichungsnummer: **0 045 057**
**B1**

(12) # EUROPÄISCHE PATENTSCHRIFT

(45) Veröffentlichungstag der Patentschrift:
**31.10.84**

(51) Int. Cl.³: **H 01 L 21/68, C 23 C 13/08**

(21) Anmeldenummer: **81105802.3**

(22) Anmeldetag: **22.07.81**

(54) Vorrichtung zur Halterung von kreisförmigen Substratscheiben.

(30) Priorität: **28.07.80 DE 3028536**

(43) Veröffentlichungstag der Anmeldung:
**03.02.82 Patentblatt 82/5**

(45) Bekanntmachung des Hinweises auf die Patenterteilung:
**31.10.84 Patentblatt 84/44**

(84) Benannte Vertragsstaaten:
**DE FR GB IT**

(56) Entgegenhaltungen:
**WO - A - 79/00510
US - A - 4 189 230
US - A - 4 241 698**

**IBM TECHNICAL DISCLOSURE BULLETIN, Band 22, Nr. 12, Mai 1980, New York LENNON, JR. "Wafer Holder for Evaporation" Seiten 5354 bis 5355
IBM TECHNICAL DISCLOSURE BULLETIN, Band 22, Nr. 6, November 1979, New York CCMERFORD "One-Shot Evaporant Thickness Gauge - Controller" Seite 2509**

(73) Patentinhaber: **Siemens Aktiengesellschaft, Berlin und München Wittelsbacherplatz 2, D-8000 München 2 (DE)**

(72) Erfinder: **Bonu, Bonu, Dipl.-Ing., Johann Clanzestrasse 53, D-8000 München 70 (DE)**

EP 0 045 057 B1

## Beschreibung

Die vorliegende Erfindung betrifft eine Vorrichtung zur Halterung von kreisförmigen Substratscheiben, insbesondere Halbleiterscheiben, bei der kreisförmige Ringe vorgesehen sind, an denen zum Ringinnern hin eine Auflagefläche für die in den betreffenden Ring jeweils einzulegende Substratscheibe vorgesehen ist und bei der Mittel zum Andruck der Substratscheiben gegen die Auflagefläche vorgesehen sind.

Zur Halterung von kreisförmigen Substratscheiben, insbesondere Halbleiterscheiben, werden zur Herstellung von an den Substratscheiben anzubringenden Überzügen aus Metallen, Oxyden u. ä., z. B. durch Bedampfungsprozesse oder Aufsputterprozesse, Vorrichtungen benötigt, die die Entstehung eines möglichst gleichmäßig aufgebrachten Überzugs ermöglichen. Für Elektronenstrahl-Bedampfungsanlagen, die zur Metallisierung von Halbleiterscheiben eingesetzt werden, ist aus Airco Telemescal, Vacuum Systems, Components & Technical Literature, Issue I, 1972/73, S. 111 bis 116, ein Substratträger bekannt, der aus einer Reihe von nebeneinander geschweißten Metallscheiben besteht. An jeder Metallscheibe ist zur Fixierung der Halbleiterscheibe eine bewegliche Metallklammer angebracht. Weiterhin ist bekannt, an den Metallscheiben eine Feder und zwei kleine Anschlagbügel vorzusehen, so daß nach dem Einlegen der Halbleiterscheiben diese mit der Feder gegen die Anschlagbügel gedrückt und damit fixiert werden. Diese Substratträger werden im allgemeinen in einem halbkugelförmigen Rezipienten angeordnet und zur gleichmäßigen Bedampfung so bewegt, daß sie sich einerseits um die eigene Achse der Halbkugel des Rezipienten drehen. Entsprechende Substratträger werden deshalb daher auch als »Planeten« bezeichnet. Die in der genannten Literaturstelle beschriebene Vorrichtung entspricht der eingangs gegebenen Definition.

Ferner ist in der US-PS 4 189 230 eine Vorrichtung zur Halterung von kreisförmigen Substratscheiben beschrieben, welche einen quadratischen Rahmen mit einer kreisförmigen Ausnehmung aufweist, an der ein kreisringförmiger Flansch befestigt ist. Diese weist eine zum Inneren hin vorspringede Auflagefläche sowie eine Blattfeder auf, welche die Substratscheiben gegen die Auflagefläche drückt. Aus »IBM Techn. Discl. Bull., Vol. 22, No. 12 (1980), S. 5354/5355, ist es bekannt, kreisförmige Ringe als Substrathalter zu verwenden. Schließlich ist aus WO-A1 79/00 510 ein Substrathalter bekannt, der sechs periphere Öffnungen aufweist, die konzentrisch um eine kreisförmige Mittenöffnung angeordnet sind, wobei die Kreise an einem Punkt ihres Umfangs sich gegenseitig berühren.

Es hat sich nun gezeigt, daß die Bestückung eines aus dem Stand der Technik verfügbaren Substratträgers vor allem mit dünnen Halbleiterscheiben nicht unproblematisch ist. So können beispielsweise beim Einsetzen der Scheiben mittels einer Pinzette gelegentlich Bruchstellen an der Halbleiterscheibe auftreten. Werden außerdem betreffende Substratträger bei Heißbedampfungen eingesetzt, so weisen die zu behandelnden Substratscheiben aufgrund von Unebenheiten der Metallscheiben zu den Metallscheiben einen ungleichmäßigen Kontakt und damit während der Bedampfung unterschiedliche Temperaturen auf, was sich insbesondere bei der Bearbeitung von Siliciumsubstratscheiben ungünstig bemerkbar macht. Die Temperaturunterschiede können nämlich bis zu 40° C betragen.

Aufgrund der instabilen Haltevorrichtungen steigt bei Heißbedampfungen ferner die Zahl der Ausfälle erheblich. So fallen gelegentlich Siliciumscheiben vom Substratträger, was während des Aufheizens der Scheiben zu elektrischen Kurzschlüssen insbesondere in der Heizanlage führen kann. Fallen die Scheiben während des Bedampfungsvorgangs vom Substratträger, so kann die Bedampfung durch Verunreinigung der Verdampfungsquelle mit Siliciumsplittern oder als Folge von Kurzschlüssen an der Elektronenstrahlkanone und davon bewirkten Störungen in der Steuerung unterbrochen werden. Das Fallen von Siliciumscheiben oder Siliciumsplittern in die Bedampfungsquelle führt ferner zu Metallspritzern auf den zu bedampfenden Substratscheiben.

Aufgabe der vorliegenden Erfindung ist es, hier eine Abhilfe zu schaffen und einen Substratträger vorzusehen, der in einfacher Weise mit den Substratscheiben, insbesondere Halbleiterscheiben zu bestücken ist, der außerdem die Substratscheiben zuverlässig haltert und der schließlich Temperaturunterschiede der Substratscheiben während der Bedampfung weitgehend verhindert.

Erfindungsgemäß wird hierzu die eingangs angegebene Vorrichtung zur Halterung von kreisförmigen Substratscheiben derart ausgestaltet, daß mehrere der kreisförmigen Ringe konzentrisch um ein insbesondere kreisförmiges Mittenstück angeordnet sind und daß als Mittel zum elastischen Andruck der Substratscheiben gegen die Auflagefläche an Haltearmen befestigte Druckfedern vorgesehen sind, wobei die Haltearme radial nach außen zeigend an einer am Mittenstück befestigbaren Nabe angebracht sind.

Die erfindungsgemäße Vorrichtung kann vorteilhafterweise zur Beschichtung von Substratscheiben, insbesondere zur Bedampfung von Substratscheiben eingesetzt werden.

Die Erfindung wird im folgenden anhand der als Ausführungsbeispiel zu wertenden Fig. 1 bis 11 erläutert. Die

Fig. 1 zeigt eine Draufsicht auf ein Ausführungsbeispiel einer erfindungsgemäßen Vorrichtung zur Halterung von kreisförmigen Substratscheiben. Die

Fig. 2 zeigt einen Querschnitt durch dieses Ausführungsbeispiel längs der Linie II-II der Fig. 1. Die

Fig. 3 zeigt in Draufsicht ein Mittel zum elastischen Andruck der Substratscheiben. Die

Fig. 4 einen Querschnitt längs der Linie IV-IV der Fig. 3. Die

Fig. 5 zeigt eine erfindungsgemäße Druckfeder. Die

Fig. 6 bis 9 zeigen weitere Ausführungsformen für Mittel zum elastischen Andruck der Substratscheiben. Die

Fig. 10 und 11 zeigen einen zur Messung der Dicke der Beschichtung bzw. des Überzugs geeigneten Testriegelhalter.

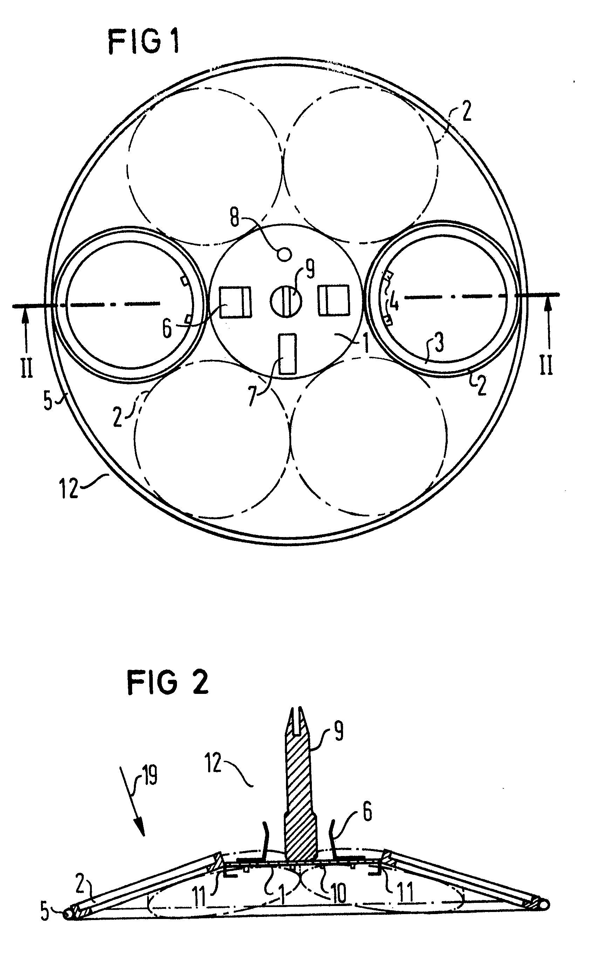

Das in der Fig. 1 gezeigte Ausführungsbeispiel für einen erfindungsgemäßen Substrathalter besteht aus sechs konzentrisch um ein kreisförmiges Mittenstück 1 angeordneten kreisförmigen Ringen 2, zu deren Mitte hin als Auflagefläche ein Randstreifen 3 und zwei Vorsprünge 4 angeordnet sind. Die Ringe 2 und das Mittenstück 1 sind aus Metall gefertigt und an ihren Berührungspunkten miteinander, z. B. durch Schweißen verbunden. Die kreisförmigen Ringe 2 sind außen von einem mit ihnen verschweißten Stabilisierungsring 5 umgeben.

Auf dem Mittenstück 1 sind zur Befestigung eines Mittels zum elastischen Andruck der Substratscheiben gegen die Auflageflächen 3 und 4 Druckfedern 6 angeordnet. Weiterhin ist auf dem Mittenstück 1 ein Stab 7 zur Befestigung eines an anderer Stelle beschriebenen Riegelhalters, ein Führungsstift 8 und eine zum Eingriff in Antriebsmittel geeignete Antriebswelle 9 angebracht.

Die Fig. 2 zeigt einen Querschnitt einer erfindungsgemäßen Vorrichtung längs der Linie II-II der Fig. 1. Zum Anbringen einer weiteren Substratscheibe sind am Mittenstück 1 mindestens drei höckerartige Auflagepunkte 10 und mindestens zwei federnde Halteklammern 11 angeordnet.

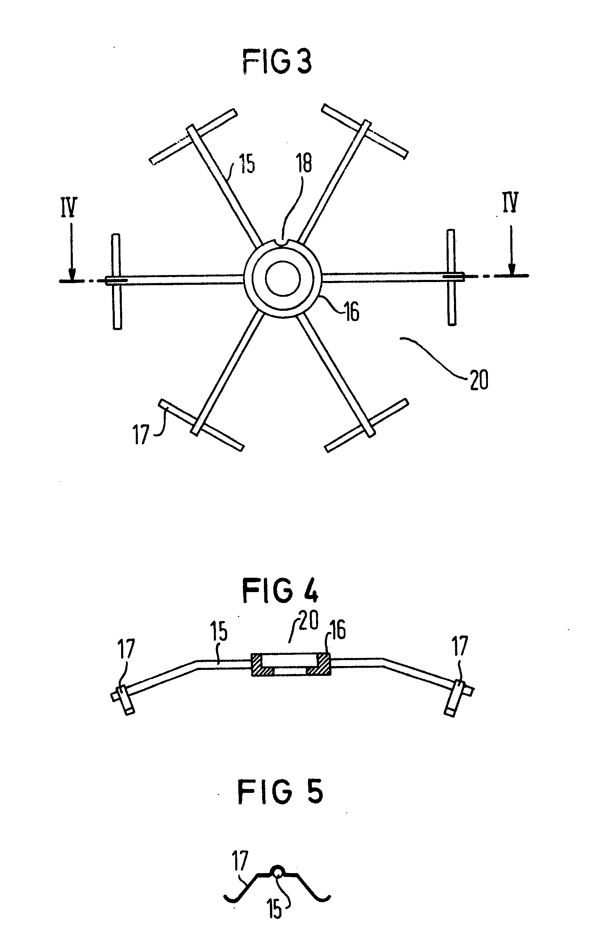

Die Fig. 3 zeigt in Draufsicht ein Ausführungsbeispiel für ein Mittel 20 zum elastischen Andruck der Substratscheiben gegen die Auflageflächen. Es besteht aus Haltearmen 15, die spinnenförmig und radial nach außen zeigend an einer am Mittenstück 1 befestigbaren Nabe 16 angebracht sind. Es ist aber auch möglich, die Haltearme 16 am Stabilisierungsring 5 zu befestigen. Am von der Nabe 16 entfernten Ende der Haltearme 15 sind Druckfedern 17 angebracht, die so ausgeführt sind, daß sie die Substratscheiben nur an zwei Punkten berühren. Bei Verwendung von dicken Substratscheiben kann auf die Verwendung von Druckfedern 17 verzichtet werden, wenn die Haltearme 15 entsprechend elastisch ausgeführt sind.

Die Fig. 4 zeigt einen Querschnitt durch die Andruckvorrichtung 20 der Fig. 3 längs der Linie IV-IV. Die Fig. 5 zeigt eine Druckfeder 17. Die Nabe 16 ist mit einem Führungsschlitz 18 versehen, in den beim Aufsetzen der Halterungsvorrichtung 20 auf den Substrathalter 12 der Führungsstift 8 eingreift und somit den gleichbleibenden Sitz der Andruckvorrichtung 20 in bezug auf den Substrathalter 12 gewährleistet.

Die erfindungsgemäße Vorrichtung wird wie folgt bedient:

Die Substratscheiben, beispielsweise 0,4 mm dicke Siliciumscheiben, werden mittels einer Saugpinzette aus einem Vorratsbehälter angehoben und so entsprechend der Pfeilrichtung 19 in die Ringe 2 gelegt, daß sie auf den Auflageflächen 3 und 4 aufliegen. Anschließend wird die Halterung 20 über die Antriebswelle 9 so auf den Substrathalter 12 geschoben, daß der Führungsstift 8 in den Führungsschlitz 18 eingreift und die Druckfedern 6 zur Befestigung der Halterung 20 einrasten. Somit werden mittels der Druckfedern 17 die Substratscheiben an die Auflageflächen 3 und 4 gedrückt und dadurch sicher gehalten. Auf diese Weise gelingt es, gleichmäßige Drücke bei der Befestigung der Scheiben zu erzielen und Brüche zu verhindern.

Im Gegensatz zu dem aus den Stand der Technik bekannten Substratträgern aus Metallscheiben gewährleistet der erfindungsgemäße Substratträger mit Ringen 2 und flächenmäßig kleinen Auflageflächen 3 und 4 eine erheblich verbesserte Temperaturkonstanz der Substratscheiben. Das Einsetzen der Substratscheiben in den erfindungsgemäßen Substratträger ist unkompliziert und rasch zu bewerkstelligen. Durch die Bestückung des Mittenstücks 1 mit höckerartigen Auflagepunkten 10 und Halteklammern 11 wird eine punktförmige Kontaktierung einer weiteren eingesetzten Substratscheibe ermöglicht, wobei diese Anordnung der Substratscheibe ähnliche thermische Bedingungen ermöglicht wie den Scheiben, die in den Ringen 2 gehalten sind.

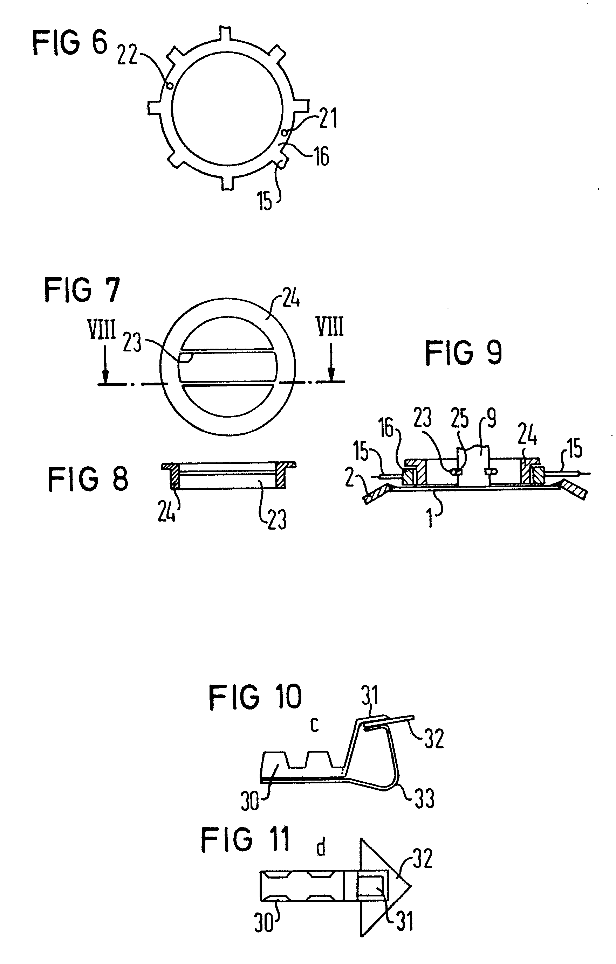

Die Fig. 6 zeigt eine Befestigungsvariante für ein erfindungsgemäßes Andruckmittel 20. Die Nabe 16 ist hier mit zwei unterschiedlich großen Führungsösen 21 und 22 versehen, in die entsprechende auf dem Mittenstück 1 angeordnete Führungsstifte eingreifen und eine Fixierung ermöglichen.

Weiterhin ist es möglich, die Nabe 16 mittels eines in den Fig. 7 bis 9 dargestellten Verschlußringes 24 zu befestigen. Die Fig. 7 zeigt den Verschlußring 24 in Draufsicht, während die Fig. 8 einen Querschnitt durch den Verschlußring 24 längs der Linie VIII-VIII der Fig. 7 zeigt. Die Fig. 9 zeigt einen Ausschnitt aus einem Querschnitt längs der Linie II-II der Fig. 1 mit mittels des Verschlußringes 24 befestigter Nabe 16.

An der Antriebswelle 9 sind zwei Arretierschlitze 25 vorgesehen, in die je ein an dem Verschlußring 24 angeordneter Federdraht 23 eingreifen kann. Die Nabe 16 wird dann durch den Verschlußring 24 fixiert.

Auf diese Weise ist es in einfacher Weise möglich, durch eine Drehung des Verschlußringes 24 die Halterungsvorrichtung 20 zu fixieren bzw. eine entsprechende Fixierung aufzuheben.

Der erfindungsgemäße Substrathalter kann nicht nur, wie im Ausführungsbeispiel der Fig. 1 gezeigt, einen, sondern auch mehrere Ringe von Kreisen 2 aufweisen. Bei entsprechender Ausführung der »Ringe« 2 ist es selbstverständlich auch möglich, andere als kreisförmige Substratscheiben zu haltern. Sind mehrere Kreise von Ringen 2 vorgesehen, so sind entsprechend mehr Haltearme 15 vorzusehen, oder ein Haltearm 15 mit mehreren Druckfedern 17 zu versehen oder entsprechende Abwandlungen vorzusehen. Vorteilhafterweise werden die Ringe 2 sphärisch angeordnet, wie z. B. in der Fig. 2 angedeutet.

Zur Messung der aufgedampften Schichtdicke kann ein Riegelhalter dienen, der am am Mittenstück 1 befestigten Stab 7 arretiert wird und einen Testriegel 32 aus dem zu bedampfenden Material, beispielsweise Silicium, haltert. Wie in Fig. 10 im Querschnitt und in Fig. 11 in Draufsicht gezeigt, besteht der Riegelhalter 30 aus einer Abdeckplatte 31 und einer einen einsetzbaren, beispielsweise dreieckigen Testriegel 32 gegen die Abdeckplatte 31 drückenden Druckfeder 33. Um eine genaue Messung der aufgedampften Schichtdicke zu ermöglichen, ist die Abdeckplatte 31 zum Testriegel 32 hin beispielsweise entsprechend einer scharfen Messerschneide angeschrägt. Damit erzielt man eine senkrechte Kante der aufgedampften Schicht, die eine unmittelbare mechanische Messung zuläßt.

Durch einen entsprechend gehalterten Testriegel wird die Messung der aufgedampften Metallschichtdicke erheblich vereinfacht, da es nun nicht mehr nötig ist, zu diesem Zwecke zunächst eine Testscheibe zu bedampfen, diese danach streifenweise zu belacken, aufzuheizen, zu ätzen, den Lack abzulösen und anschließend die Schichtdicke zu messen.

**Patentansprüche**

1. Vorrichtung zur Halterung von kreisförmigen Substratscheiben, insbesondere Halbleiterscheiben, bei der kreisförmige Ringe vorgesehen sind, an denen zum Ringinnern hin eine Auflagefläche für die in den betreffenden Ring jeweils einzulegende Substratscheibe vorgesehen ist und bei der Mittel zum Andruck der Substratscheiben gegen die Auflagefläche vorgesehen sind, dadurch gekennzeichnet, daß mehrere dieser kreisförmigen Ringe (2) konzentrisch um ein insbesondere kreisförmiges Mittenstück (1) angeordnet sind und daß als Mittel zum elastischen Andruck der Substratscheiben gegen die Auflagefläche (3, 4) an Haltearmen (15) befestigte Druckfedern (17) vorgesehen sind, wobei die Haltearme radial nach außen zeigend an einer am Mittenstück befestigbaren Nabe (16) angebracht sind.

2. Vorrichtung nach Anspruch 1, dadurch gekennzeichnet, daß als Auflagefläche ein an der Ringinnenseite angeordneter Randstreifen (3) vorgesehen ist.

3. Vorrichtung nach Anspruch 1 oder 2, dadurch gekennzeichnet, daß als Auflagefläche (3, 4) mindestens ein an der Ringinnenseite angeordneter Vorsprung (4) vorgesehen ist.

4. Vorrichtung nach einem der Ansprüche 1 bis 3, dadurch gekennzeichnet, daß die kreisförmigen Ringe (2) so angeordnet sind, daß sie sich gegenseitig an mindestens einem Punkt ihres Umfangs berühren.

5. Vorrichtung nach einem der Ansprüche 1 bis 4, dadurch gekennzeichnet, daß die kreisförmigen Ringe außen von einem Stabilisierungsring (5) umfaßt sind.

6. Vorrichtung nach einem der Ansprüche 1 bis 5, dadurch gekennzeichnet, daß die Druckfedern (17) so ausgeführt sind, daß sie die Substratscheiben an zwei Punkten berühren.

7. Vorrichtung nach einem der Ansprüche 1 bis 6, dadurch gekennzeichnet, daß die Nabe (16) mittels federnder Klammern (6) am Mittenstück (1) befestigbar sind und daß die Nabe (16) mit Führungsmitteln (18) versehen ist, die ihren gleichbleibenden Sitz gewährleisten.

8. Vorrichtung nach einem der Ansprüche 1 bis 7, dadurch gekennzeichnet, daß das Mittenstück (1) als Metallscheibe ausgeführt ist, an deren einer einer Antriebswelle (9) gegenüberliegender Oberfläche mindestens drei höckerartige Auflagepunkte (10) angeordnet sind und an deren Umfang mindestens zwei federnde Halteklammern (11) angebracht sind.

9. Vorrichtung nach einem der Ansprüche 1 bis 8, dadurch gekennzeichnet, daß am Mittenstück (1) Mittel (7) zur Aufnahme eines Testriegelhalter (30) vorgesehen sind und daß der Testriegelhalter (30) eine an mindestens einer Kante angeschrägte Abdeckplatte (31) und eine einen einsetzbaren Testriegler (32) gegen die Abdeckplatte (31) drückende Druckfeder (33) aufweist.

**Claims**

1. Apparatus for holding disc-shaped substrates, in particular semiconductor discs, in which circular rings are provided, on which at the insides of the rings, there is arranged a contact surface for the substrate disc which is to be inserted into the respective ring, and in which means are provided for pressing the substrate discs against the contact surface, characterised in that a plurality of these circular rings (2) are concentrically arranged around a central element (1), which , in particular, is circular, and that compression springs (17), which are secured to holding arms (15), are provided as means for elastically pressing the substrate discs against the contact surfaces (3, 4), the holding arms being fixed to a hub (16), which can be secured to the central element, so as to be radially pointing outwardly.

2. Apparatus according to claim 1, characterised in that a peripheral strip (3) arranged at the inside of the ring is provided as contact surface.

3. Apparatus according to claim 1 or 2, characterised in that at least one projection (4) arranged on the inside of the ring is provided as contact surface (3, 4).

4. Apparatus according to one of claims 1 to 3, characterised in that the circular rings (2) are so arranged that they contact each other at at least one point of their periphery.

5. Apparatus according to one of claims 1 to 4, characterised in that the circular rings are surrounded on the outside by a stabilizing ring (5).

6. Apparatus according to one of claims 1 to 5, characterised in that the compression springs (17) are so formed that they contact the substrate discs at two points.

7. Apparatus according to one of claims 1 to 6, characterised in that the hub (16) can be secured to the central element (1) by means of resilient clamps (6), and that the hub (16) is provided with guide means (18) which ensure its constant siting.

8. Apparatus according to one of claims 1 to 7, characterised in that the central element (1) is formed as a metal disc on the surface of which lying opposite a drive shaft (9), are arranged at least three hump-like contact points (10) and at the periphery of which at least two resilient holding clamps (11) are arranged.

9. Apparatus according to one of claims 1 to 8, characterised in that means (7) for housing a test bar holder (30) are arranged an the central element (1), and that the test bar holder (30) has a cover plate (31) which is sloped on at least one edge and a compression spring (33) which presses the cover plate (31) against an insertable test bar (32).

**Revendications**

1. Appareil pour maintenir des disques circulaires formant substrat, notamment des disques semiconducteurs, dans lequel sont prévus des anneaux de forme circulaire sur lesquels est prévue vers l'intérieur de l'anneau une surface d'appui pour les disques formant substrat à introduire dans l'anneau concerné et dans lequel des moyens sont prévus pour appliquer les disques formant substrat sur les surfaces d'appui, caractérisé en ce que plusieurs de ces anneaux (2) de forme circulaire sont disposés concentriquement autour d'une pièce centrale (1), notamment de forme circulaire, et en ce que des ressorts de pression (17) fixés à des bras de maintien (15) sont prévus comme moyens pour appliquer élastiquement les disques formant substrat sur les surfaces d'appui (3, 4), les bras de maintien étant fixés, en étant dirigés radialement vers l'extérieur, à un moyeu (16) qui peut être fixé à la pièce centrale.

2. Appareil suivant la revendication 1, caractérisé en ce qu'il est prévu comme surface d'appui une bande marginale (3) disposée sur le côté intérieur de l'anneau.

3. Appareil suivant la revendication 1 ou 2, caractérisé en ce qu'il est prévu comme surface d'appui (3, 4) au moins une partie en saillie (4) disposée du côté intérieur de l'anneau.

4. Appareil suivant l'une des revendications 1 à 3, caractérisé en ce que les anneaux de forme circulaire sont disposés de manière à être mutuellement en contact au moins en un point de leur pourtour.

5. Appareil suivant l'une des revendications 1 à 4, caractérisé en ce que les anneaux de forme circulaire sont entourés extérieurement par un anneau de stabilisation (5).

6. Appareil suivant l'une des revendications 1 à 5, caractérisé en ce que les ressorts de pression (17) sont conçus de manière à ce que les disques formant substrat soient en contact en deux points.

7. Appareil suivant l'une des revendications 1 à 6, caractérisé en ce que les moyeux (16) peuvent être fixés à la pièce centrale (1) au moyen d'agrafes élastiques (6) et en ce que les moyeux (16) sont munis de moyens de guidage (18) qui leur assurent un ajustement constant.

8. Appareil suivant l'une des revendications 1 à 7, caractérisé en ce que la pièce centrale (1) est agencée en disque métallique sur la surface duquel qui est opposée à un arbre d'entraînement (9) sont disposés au moins trois points d'appui (10) de type à bossage et sur le pourtour duquel sont fixées au moins deux agrafes élastiques de maintien (11).

9. Appareil suivant l'une des revendications 1 à 8, caractérisé en ce que sur la pièce centrale (1) sont prévus des moyens (7) de réception d'un porte-éprouvette (30) et en ce que le porte-éprouvette (30) présente une plaque de recouvrement (31) biseautée au moins sur un bord et un ressort de pression (33) repoussant sur la plaque de recouvrement (31) une éprouvette (32) susceptible d'être introduite.

## FIG 1

## FIG 2

## FIG 3

## FIG 4

## FIG 5

**FIG 6**

**FIG 7**

**FIG 8**

**FIG 9**

**FIG 10**

**FIG 11**